# EUROPEAN PATENT APPLICATION

(11) **EP 4 842 153 A1**
(43) Date of publication of application: **18.11.2026**
(21) Application number: 25188156.1
(22) Date of filing: 08.07.2025
(51) Int. Cl.: H05K 7/20

(54) **IMMERSION COOLING DEVICE**

(30) Priority: 13.05.2025 US 202519206917
(71) Applicant: Cooler Master Co., Ltd., Taipei City 114065 (TW)
(72) Inventor: WONG, Sai Kiu, 114065 Taipei City (TW); PENG, Cheng-Shu, 114065 Taipei City (TW)
(74) Representative: Grünecker Patent- und Rechtsanwälte PartG mbB

(57) **Abstract**

An immersion cooling device includes a tank that contains a working fluid, and at least two immersion cooling modules that are arranged in series within the tank and are submerged in the working fluid, each immersion cooling module thermally coupled to a corresponding heat-generating device. The immersion cooling module, includes a flow-directing housing having a main housing body and a terminal flow guide, the main housing body having an inlet face and a top wall that defines at least one top-wall outlet, and the terminal flow guide being coupled to the main housing body on a side opposite the inlet face a plurality of heat-dissipating fins disposed within the main housing body, and at least one fluid driver mounted to the inlet face.

## Description

### TECHNICAL FIELD

The present disclosure relates to cooling device, and in particular to an immersion cooling device, an active heat dissipation module, and an active flow guide structure.

### BACKGROUND

General liquid cooling heat dissipation methods can be classified into direct contact liquid cooling and immersion cooling. Immersion cooling is further divided into two types: single-phase one and two-phase one. The structure of a single-phase immersion liquid cooling device is relatively simple. Alongside the benefits of low noise and enhanced energy efficiency from the absence of fans, the cooling liquid remains in a singular phase without undergoing a phase transition, eliminating the need for airtight sealing and pressure control.

The single-phase immersion cooling flow-guiding system is intended for usage in high-power and high-density collaborative computing servers. Under constraints such as limited module spacing and stringent power requirements, the system described in this disclosure aims to reduce thermal interference between serially connected cooling modules, thereby enhancing the overall cooling efficiency of each module.

### SUMMARY

The present disclosure provides a system of at least two single-phase immersion cooling modules. In particular, the system incorporates a flow-guiding mechanism within the single-phase immersion cooling system to prevent excessive mixing between the heated fluid from upstream modules and the cooled fluid intended for downstream modules.

The invention is as claimed in the appended claims. One aspect of the present disclosure is an immersion cooling device. The immersion cooling device includes a tank that contains a working fluid, and at least two immersion cooling modules that are arranged in series within the tank and are submerged in the working fluid, each immersion cooling module thermally coupled to a corresponding heat-generating device. The immersion cooling modules includes a flow-directing housing having a main housing body and a terminal flow guide, the main housing body having an inlet face and a top wall that defines at least one top-wall outlet, and the terminal flow guide being coupled to the main housing body on a side opposite the inlet face, a plurality of heat-dissipating fins disposed within the main housing body, and at least one fluid driver mounted to the inlet face.

In one embodiment, the at least two immersion cooling modules are spaced apart by a spacing that is adjustable.

In one embodiment, the terminal flow guide includes a flow-guiding back plate and a base that together define a flow development region.

In one embodiment, the top-wall outlet is located within the top-wall outlet region that extends from the flow-guiding back plate to a midpoint of the heat-dissipating fins.

In one embodiment, the flow development region has a length between 2 mm and 20 mm.

In one embodiment, the flow-guiding back plate is inclined at an angle between 0° and 45° relative to the flow development region.

In one embodiment, the flow-guiding back plate includes one or more bends.

In one embodiment, the bend in the flow-guiding plate forms at least two angled segments.

In one embodiment, the top-wall outlet includes multiple discrete rectangular openings.

In one embodiment, the top-wall outlet is arranged in a geometric array.

In one embodiment, the fluid driver generates forced convection to transport heated working fluid from the heat-dissipating fins to the top-wall outlet.

This summary is provided to introduce a selection of concepts in a simplified form that are further described below in the Detailed Description. This summary is not intended to identify key features or essential features of the claimed subject matter, nor is it intended to be used to limit the scope of the claimed subject matter.

### BRIEF DESCRIPTION OF THE DRAWINGS

FIG. 1A is a schematic diagram of an immersion cooling device according to one embodiment of the present disclosure.
FIGS. 1B and 1D are graphs illustrating the relationship between the chip (heat-generating device) temperature and the module spacing.
FIGS. 1C and 1E are tables illustrating the detailed temperature values for each module spacing.
FIG. 2A is a schematic diagram illustrating the components of an immersion cooling module according to one embodiment of the present disclosure.
FIG. 2B is a schematic diagram illustrating an external view of the immersion cooling module of FIG. 2A.
FIG. 2C is a schematic diagram illustrating a longitudinal cross-sectional view of the immersion cooling module of FIG. 2A.
FIGS. 2D and 2E are tables illustrating detailed temperature and thermal resistance values for the chip (heat-generating device) coupled to the immersion cooling module with and without the terminal flow guide, evaluated across different module spacings.
FIG. 3A is a schematic diagram illustrating a longitudinal cross-sectional view of an immersion cooling module according to one embodiment of the present disclosure.
FIGS. 3B and 3C are graphs illustrating the relationship between the chip (heat-generating device) temperature and the flow development region length.
FIG. 3D is a table illustrating detailed temperature values for the chip (heat-generating device) coupled to the immersion cooling module with different flow development region length.
FIG. 3E is a table illustrating detailed temperature and thermal resistance values for the chip (heat-generating device) coupled to the immersion cooling module with and without the terminal flow guide, evaluated across different flow development region length.
FIG. 4A is a schematic diagram illustrating a longitudinal cross-sectional view of an immersion cooling module according to one embodiment of the present disclosure.
FIG. 4B is a table illustrating detailed temperature and thermal resistance values for the chip (heat-generating device) coupled to the immersion cooling module with and without the terminal flow guide.
FIGS. 5A-5C are schematic diagrams illustrating the top views of immersion cooling modules of FIG. 2B with different top-wall outlet regions.
FIGS. 5D-5E are graphs illustrating the relationship between the chip (heat-generating device) temperature and the top-wall outlet range.
FIG. 5F is a table illustrating detailed temperature values for the chip (heat-generating device) coupled to the immersion cooling modules with different top-wall outlet ranges.
FIG. 6A is a schematic diagram illustrating a top view of an immersion cooling module according to one embodiment of the present disclosure.
FIG. 6B is a table illustrating detailed temperature and thermal resistance values for the chip (heat-generating device) coupled to the immersion cooling module with and without the terminal flow guide.
FIG. 7A is a schematic diagram illustrating a top view of an immersion cooling module according to one embodiment of the present disclosure.
FIG. 7B is a schematic diagram illustrating a top view of an immersion cooling module according to one embodiment of the present disclosure.
FIG. 7C is a table illustrating detailed temperature and thermal resistance values for the chip (heat-generating device) coupled to the immersion cooling module with and without the terminal flow guide.
FIG. 8A is a schematic diagram illustrating a longitudinal cross-sectional view of the immersion cooling module of FIG. 3A.
FIG. 8B is a schematic diagram illustrating a longitudinal cross-sectional view of an immersion cooling module according to one embodiment of the present disclosure.
FIGS. 8C-8D are graphs illustrating the relationship between the chip (heat-generating device) temperature and the flow-guiding back plate inclination angles.
FIG. 8E is a table illustrating detailed temperature values for the chip (heat-generating device) coupled to the immersion cooling module with the flow-guiding back plate inclined at different angles.

### DETAILED DESCRIPTION

Various embodiments will be described in detail with reference to the drawings, wherein like reference numerals represent like parts and assemblies throughout the several views. Reference to various embodiments does not limit the scope of the claims attached hereto. Additionally, any examples set forth in this specification are not intended to be limiting and merely set forth some of the many possible embodiments for the appended claims.

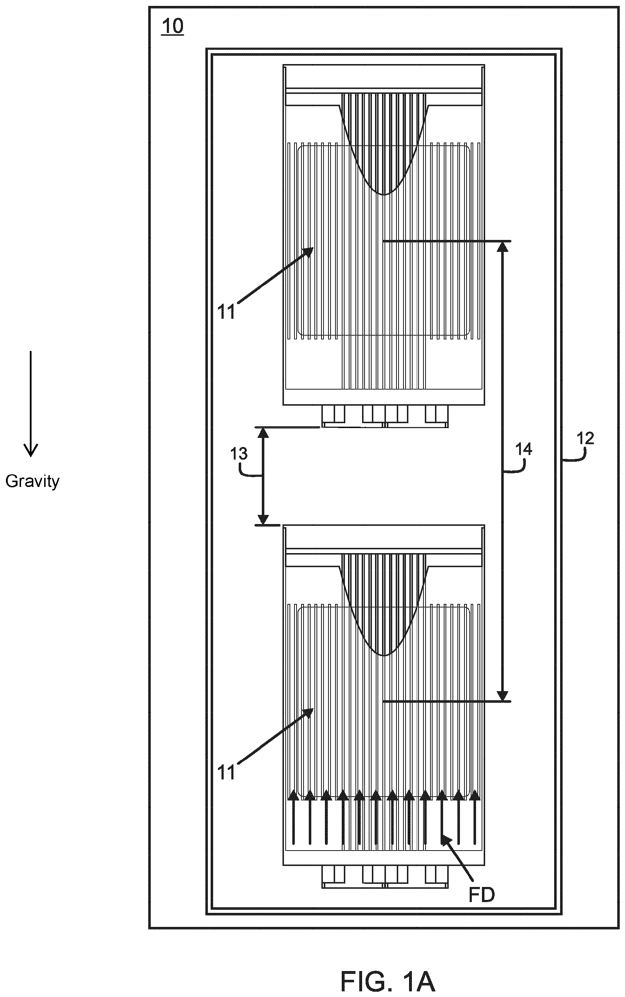

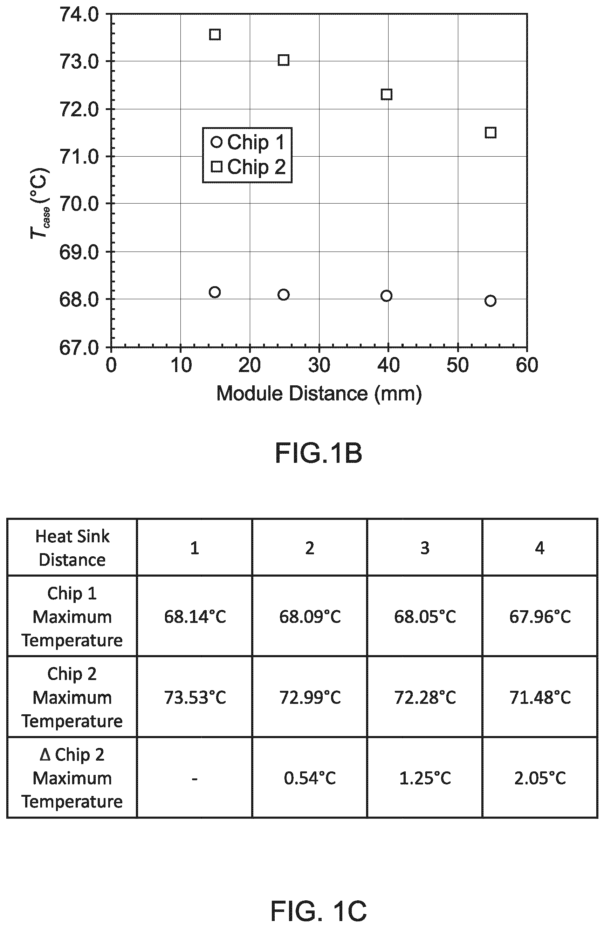

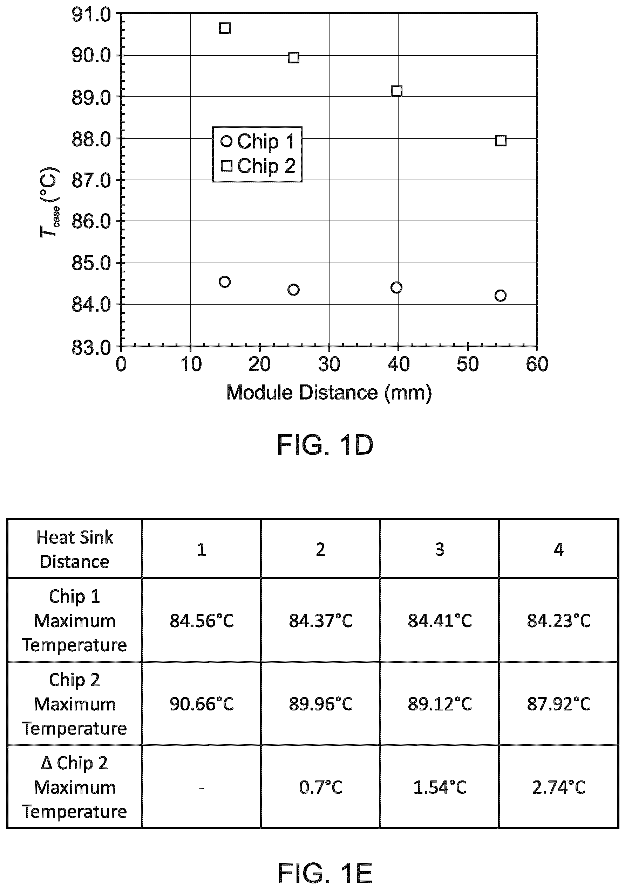

Referring to FIGS. 1A-1E. FIG. 1A is a schematic diagram of an immersion cooling device of an embodiment of the present disclosure. FIGS. 1B and 1D are graphs illustrating the relationship between the chip (heat-generating device) temperature and the module distance. FIGS. 1C and 1D are tables illustrating the detailed temperature values for each heat sink distance setting.

As an example illustrated in FIG. 1A, the immersion cooling device 10 includes a tank 12, at least two immersion cooling modules 11, and at least a heat-generating device 14. In one embodiment, the immersion cooling module 11 is a forced convection immersion cooling module. The heat-generating device 14 is mounted within or on the tank 12, which is filled with a working fluid WF, such as a cooling liquid. In the example illustrated in FIG. 1A, the immersion cooling device 10 includes two immersion cooling modules 11. However, the number of immersion cooling modules is not limited to this example and may vary in other embodiments.

In one embodiment, the immersion cooling device 10 is vertically oriented, with the fluid flow direction FD directed opposite to the direction of gravity G. As an example illustrated in FIG. 1A, the two immersion cooling modules 11 are arranged in series and spaced apart by a module spacing 13, defined as the perpendicular distance between the two immersion cooling modules 11. Each immersion cooling module 11 is mounted on a corresponding heat-generating device 14. For example, the lower immersion cooling module 11 functions as an upstream module coupled to an upstream heat-generating device, and the upper immersion cooling module 11 functions as a downstream module coupled to a downstream heat-generating device. During operation, the module passively contacts the working fluid WF to exchange heat. Simultaneously, the heated working fluid WF is actively driven along the flow direction FD toward the rear of the immersion cooling module 11 via forced convection.

In some embodiments, as the module spacing 13 varies, the thermal performance of the system changes accordingly. FIGS. 1B and 1C illustrate an example of the relationship between the module spacing 13 and the temperature of two heat-generating devices 14, *e.g.,* two chip components in when operating in a low-power mode. FIG. 1C presents four datasets corresponding to different module spacings 13, labeled as Heat Sink Distance 1 through 4. As shown, increasing the module spacing 13 from 0-25 mm to 26-50 mm results in a temperature reduction of approximately 1.25°C for the downstream heat-generating device 14, *i.e.,* Chip 2. Further increasing the module spacing to 51-75 mm may yield an even greater temperature reduction of approximately 2.05°C for the downstream heat-generating device, *i.e.,* Chip 2.

FIGS. 1D and 1E illustrate an example of the relationship between the module spacing 13 and the temperature of the two heat-generating device 14, *i.e.,* two chip components, when operating in a high-power mode. FIG. 1E presents four datasets corresponding to different module spacings 13, labeled as Heat Sink Distance 1 through 4. As shown, increasing the module spacing 13 from 0-25 mm to 26-50 mm results in a temperature reduction of approximately 1.54°C for the downstream heat-generating device 14, *i.e.,* Chip 2. Further increasing the module spacing to 51-75 mm may yield an even greater temperature reduction of approximately 2.74°C for the downstream heat-generating device 14, *i.e.,* Chip 2.

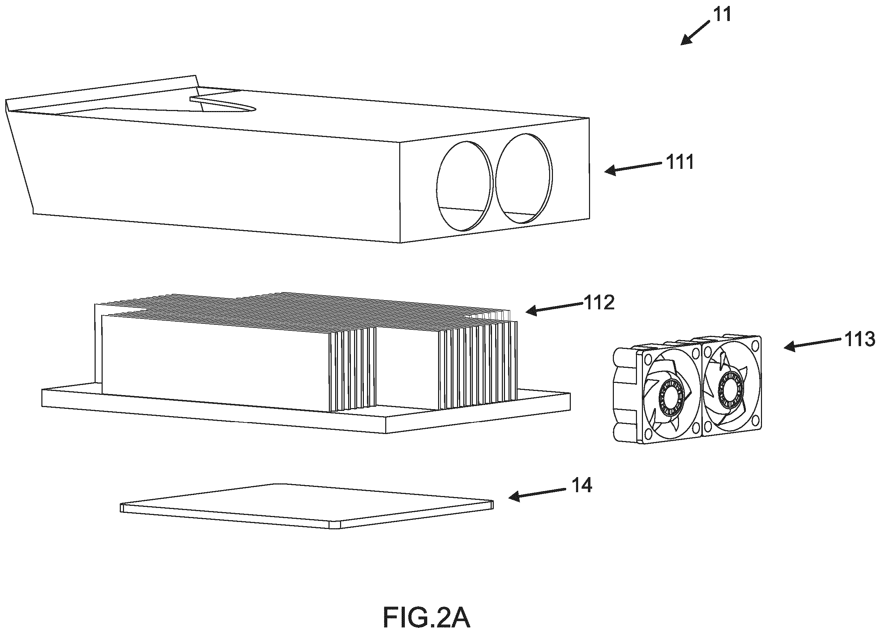

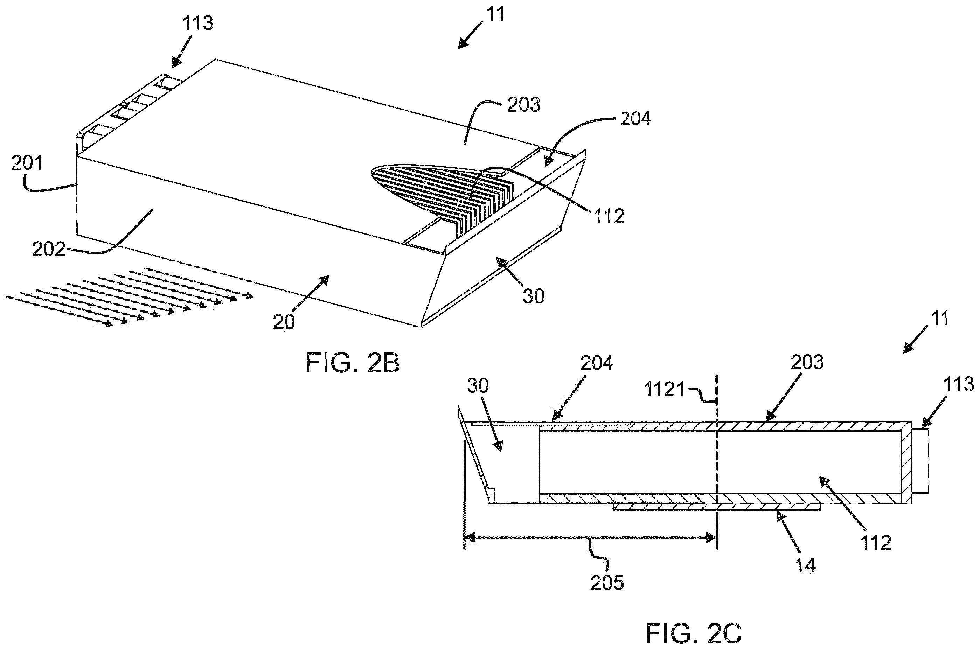

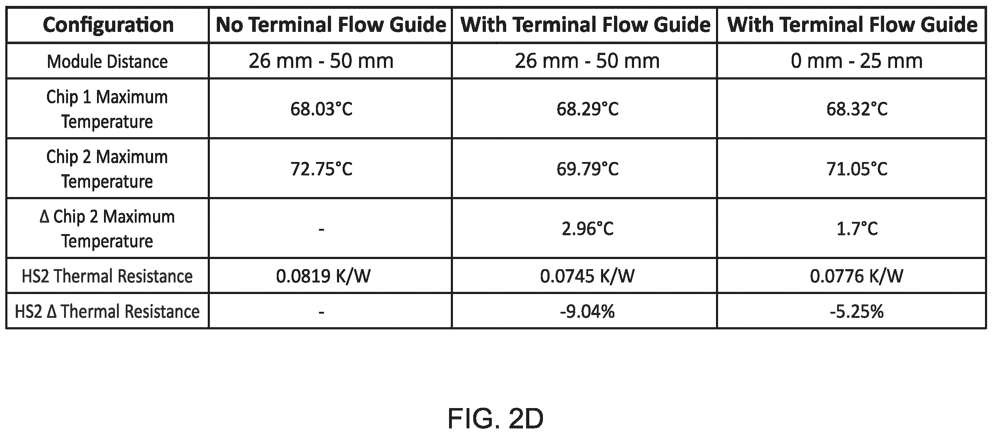

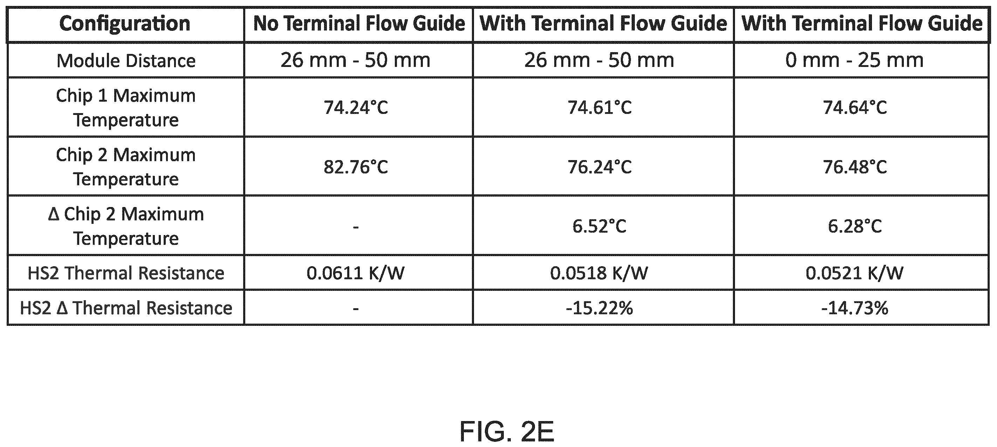

Referring to FIGS. 2A-2E. FIG. 2A is a schematic diagram illustrating the components of an immersion cooling module according to one embodiment of the present disclosure. FIG. 2B is a schematic diagram illustrating an external view of the immersion cooling module of FIG. 2A. FIG. 2C is a schematic diagram illustrating a longitudinal cross-sectional view of the immersion cooling module of FIG. 2A. FIGS. 2D and 2E are tables illustrating detailed temperature and thermal resistance values for two heat-generating devices 14, *i.e.,* two chip components, coupled to the immersion cooling module with and without the terminal flow guide, evaluated across different module spacings.

As an example illustrated in FIGS.2A-2C, the immersion cooling module 11 includes a flow-directing housing 111, a plurality of heat-dissipating fins 112 and at least one fluid driver 113. In one embodiment, the immersion cooling module 11 is configured as a forced convection immersion cooling module adapted for installation on a heat-generating device 14.

In one embodiment, the flow-directing housing 111 includes a main housing body 20 and a terminal flow guide 30. The main housing body 20 includes an inlet face 201, which serves as the mounting surface for the fluid driver 113. Opposing side walls 202 extend rearward from the inlet face 201, and a top wall 203 spans between the side walls. Together, the inlet face 201, side walls 202, and top wall 203 define a partially enclosed channel that surrounds the heat-dissipating fins 112. The terminal flow guide 30 is attached to the main housing body 20 on the side of a top-wall outlet 204 (opposite the inlet face) and is configured to guide the exiting working fluid WF in a streamlined manner, reducing turbulence and mixing of the heated fluid exiting an upstream module and the cooler fluid approaching a downstream module..

During operation, the working fluid WF is drawn into the inlet face 201 by the fluid driver 113. The working fluid WF then flows through the main housing body 200, guided across the fin assembly 112, and exits through the top-wall outlet 204. The working fluid WF is directed along a controlled path across the heat-dissipating fins 112, which are thermally coupled to the heat-generating device 14.

In one embodiment, the immersion cooling module 11 facilitates efficient heat dissipation through both conduction and convection mechanisms. The heat-dissipating fins 112 absorb thermal energy via direct contact conduction from the underlying heat-generating device 140. Simultaneously, the fluid driver 113 generates forced convection, actively driving the heated working fluid WF from the heat-dissipating fins 112 to the top-wall outlet 204 located on the top wall 203 of the flow-directing housing 111. The forced convention configuration also helps prevent excessive mixing of the heated fluid exiting an upstream module and the cooler fluid approaching a downstream module. By avoiding such thermal backflow, the design enhances thermal efficiency in serially arranged cooling modules.

In one embodiment, the terminal flow guide 30 further enhances thermal management in a serially arranged immersion cooling modules 10. As an example illustrated in FIGS. 2D and 2E, experimental data demonstrates that the inclusion of the terminal flow guide 30 reduces the temperature of the downstream heat-generating device 14, *i.e.,* Chip 2, under both low and high power conditions.

For example, when the heat-generating device 14 operates in a low-power mode and the module spacing 13 (as defined in FIG. 1A) is between 26 mm and 50 mm, the downstream heat-generating device, *i.e.,* Chip 2, experiences a temperature reduction of approximately 2.69°C, corresponding to a 9.04% decrease in thermal resistance compared to a system without the terminal flow guide 30. Under high-power operation and the same spacing, the temperature for the same chip component, *i.e.,* Chip 2, reduction increases to approximately 6.52°C, with a corresponding 15.22% reduction in thermal resistance.

Additionally, performance improvements continue to be evident despite the reduction in the module spacing 13. For instance, when the heat-generating device 14 operates in a low-power mode and the module spacing is set between 0 mm and 25 mm, the downstream heat-generating device 14, *i.e.,* Chip 2, exhibits a temperature reduction of approximately 1.7°C, with a corresponding 5.25% decrease in thermal resistance. Under high-power operation with the same reduced spacing, the temperature reduction reaches approximately 6.28°C for the same chip component, *i.e.,* Chip 2, and the thermal resistance is reduced by 14.73%. The results of dataset show that the inclusion of the terminal flow guide 30 is effective even with minimum spacing between modules.

The above experimental results indicate that the proposed forced convection immersion cooling configuration-with an integrated terminal flow guide-provide significant thermal performance advantages across varied power loads and module spacings. The design is particularly well-suited for high-power density applications where spatial constraints and thermal efficiency are crucial design factors.

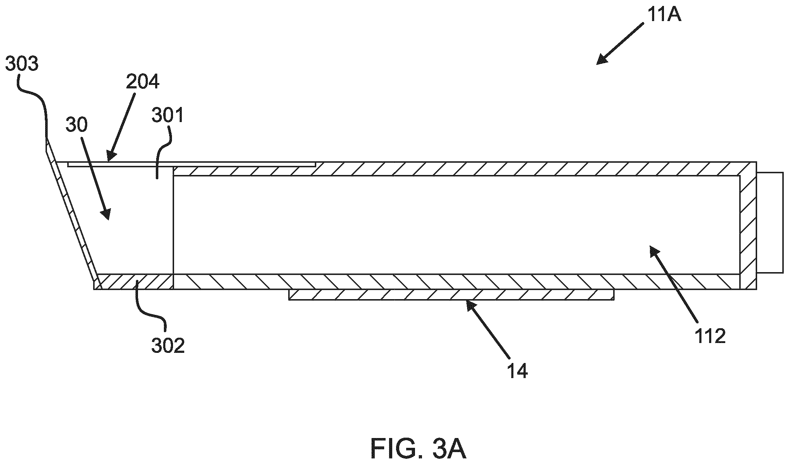

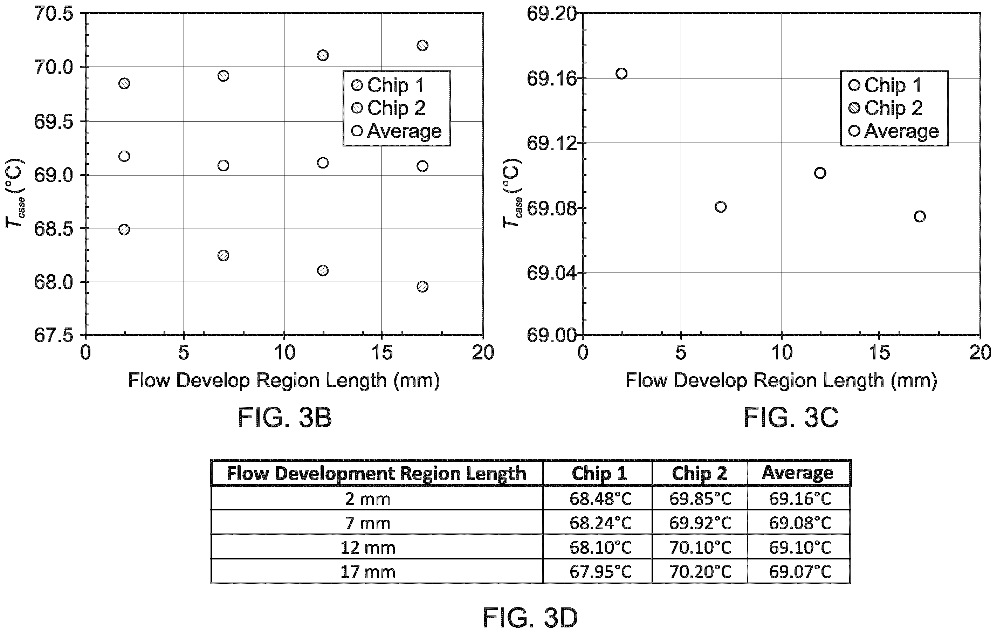

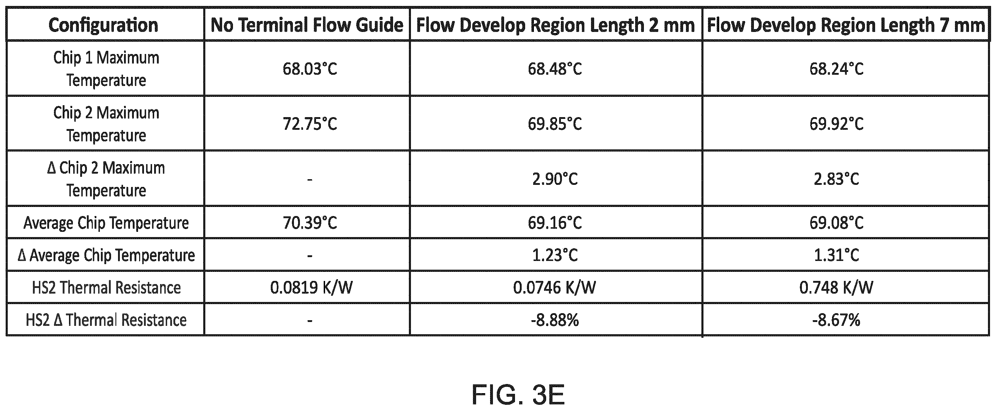

Referring to FIGS. 3A-3E. FIG. 3A is a schematic diagram illustrating a longitudinal cross-sectional view of an immersion cooling module according to one embodiment of the present disclosure. FIGS. 3B and 3C are graphs illustrating the relationship between temperature of two heat-generating devices, *i.e.,* two chip components, and the length of the flow development region. FIG. 3D is a table illustrating detailed temperature values for the two heat-generating devices, *i.e.,* two chip components, coupled to the immersion cooling module with different lengths of the flow development region. FIG. 3E is a table illustrating detailed temperature and thermal resistance values for the two heat-generating devices, *i.e.,* two chip components, coupled to the immersion cooling module with and without the terminal flow guide, evaluated across different flow development region lengths.

As an example illustrated in FIG. 3A, the immersion cooling module 11A is similar to the immersion cooling module 11 in FIG. 2A, so the differences will be described, and the similarities will not be repeated. In one embodiment, the terminal flow guide 30 of the immersion cooling module 11A includes a pair of flow guide sidewalls 301, a flow development region 302, and a flow-guiding back plate 303. In the embodiment, the base of the terminal flow guide 30 is defined by the flow development region 302. The flow development region 302 is positioned immediately downstream of the heat-dissipating fins 112, in the direction towards the flow-directing back plate 203, and has a length ranging from 0 mm to 20 mm.

In one embodiment, the flow development region 302 is designed to provide a space for mixing the working fluid WF after it exits the heat-dissipating fins 112. The mixing process helps avoiding localized hotspots in the working fluid temperature at the outlet of the immersion cooling module 11, which could otherwise impair the thermal performance of downstream modules. Further, the flow development region 302-defined as the gap between the end of the heat-dissipating fins 112 and the flow-guiding back plate 303-can be optimized to minimize pressure drop across the module.

As an example illustrated in FIGS. 3B-3D, the table provides experimental data of different flow development region 302 lengths on the temperature performance of two chips in heat-generating devices coupled with an immersion cooling device with the immersion cooling module 11A. For example, as the flow development region 302 length increases from 2 mm to 17 mm, the average temperatures remain relatively consistent, hovering around 69.07°C to 69.16°C. Chip 1 exhibits a slight cooling trend as the region length increases (from 68.48°C at 2 mm to 67.95°C at 17 mm). Chip 2, in contrast, shows a slight warming trend (from 69.85°C at 2 mm to 70.20°C at 17 mm). Despite minor individual variations, the average temperature across the chips remains stable, suggesting that flow development region length has limited influence on overall average thermal performance within the tested range.

As an example illustrated in FIG. 3E, when the heat-generating device 14 is operating, implementing a flow development region 302 with a length between 2 mm and 10 mm has shown measurable performance benefits. Compared to a system without the terminal flow guide 30, the average temperature of the heat-generating device 14, *i.e.,* the two chip components, can be reduced by up to 1.31°C. Further, in this configuration, the thermal resistance of the downstream heat-generating device 14, *i.e.,* Chip 2, is reduced by approximately 8.88%, demonstrating the effectiveness of the flow development region 302 in enhancing overall thermal management efficiency.

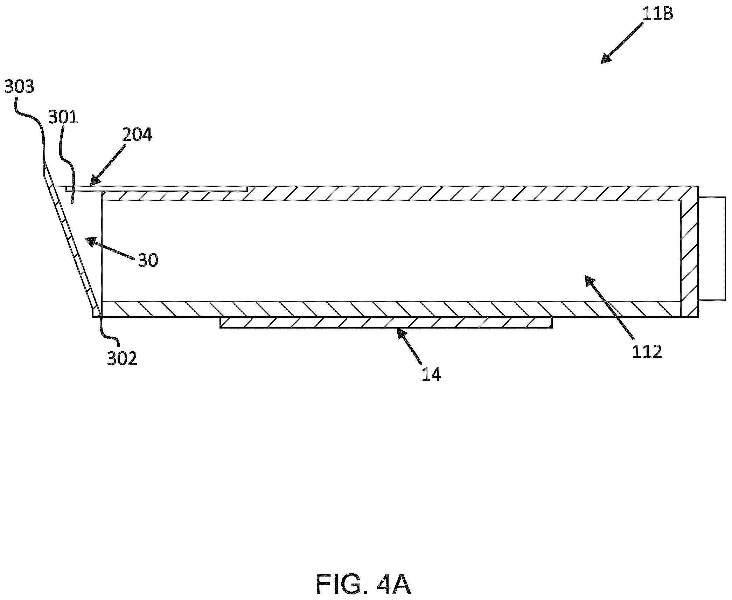

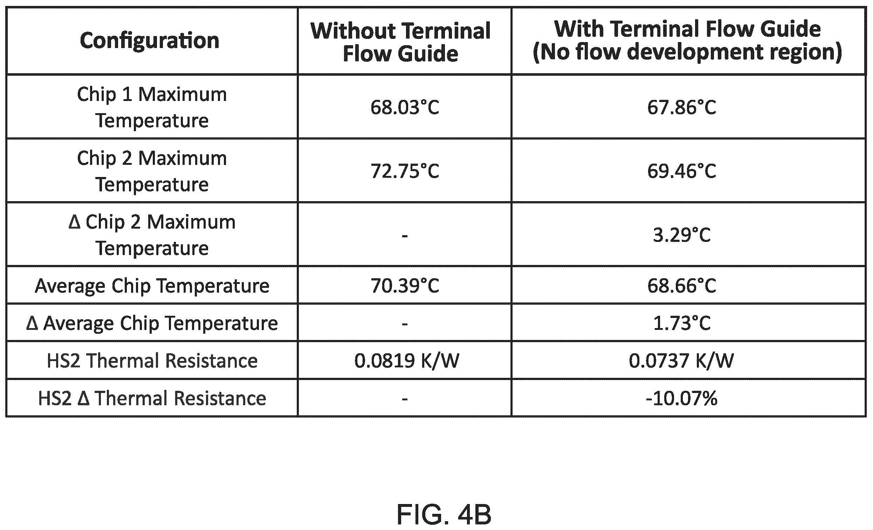

Referring to FIGS. 4A-4B. FIG. 4A is a schematic diagram illustrating a longitudinal cross-sectional view of an immersion cooling module according to one embodiment of the present disclosure. FIG. 4B is a table illustrating detailed temperature and thermal resistance values for two heat-generating devices 14, *i.e.,* two chip components, coupled to the immersion cooling module with and without the terminal flow guide.

As an example illustrated in FIG. 4A, the immersion cooling module 11B is similar to the immersion cooling module 11A in FIG. 3A, so the differences will be described, and the similarities will not be repeated. In one embodiment, the immersion cooling module 11B does not include a flow development region. In other words, the flow development region length is 0mm. For example, the rear end of the terminal flow guide 30 is formed by the flow-guiding back plate 303.

In one embodiment, the flow-guiding back plate 303 directs the working fluid WF toward the top-wall outlet 204 located on the top wall of the flow-directing housing (shown in FIG. 2A and FIG. 2B). During the operation of multiple immersion cooling modules 11 arranged in series, the flow-guiding back plate 303 prevent the heated working fluid from the upstream module from directly entering the downstream module.

As an example illustrated in FIG. 4B, experimental results shows that, when the heat-generating device 14 is in operation, the inclusion of the flow-guiding back plate 303 results in a temperature reduction of up to 3.29°C in the downstream heat-generating device, *i.e.,* Chip 2, compared to a system that lacks the flow-guiding structure 30. Furthermore, the inclusion of the flow-guiding back plate 303 reduces the thermal resistance of the downstream heat-generating device, *i.e.,* Chip 2, by approximately 10.07%, demonstrating the flow-directing back plate's efficiency in enhancing overall cooling performance.

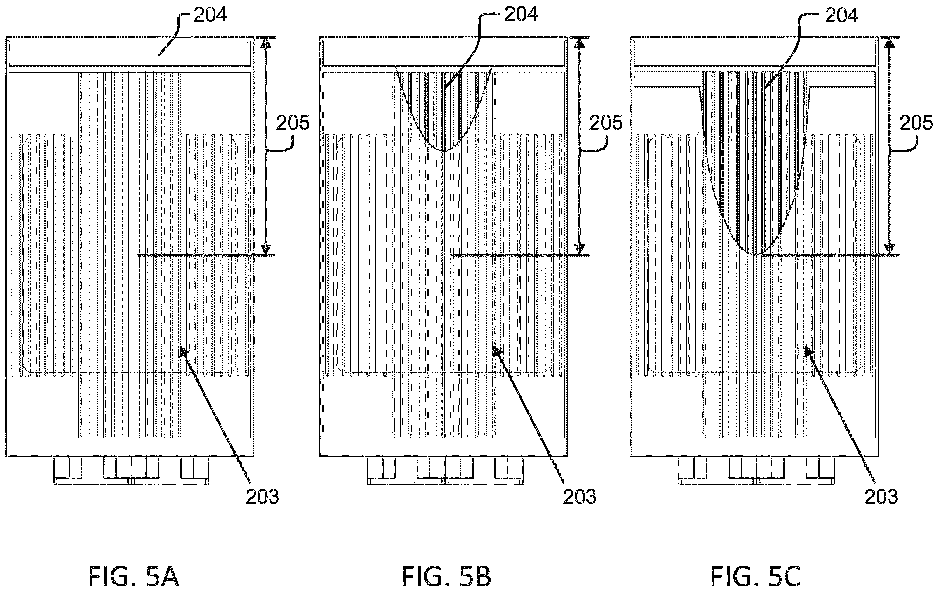

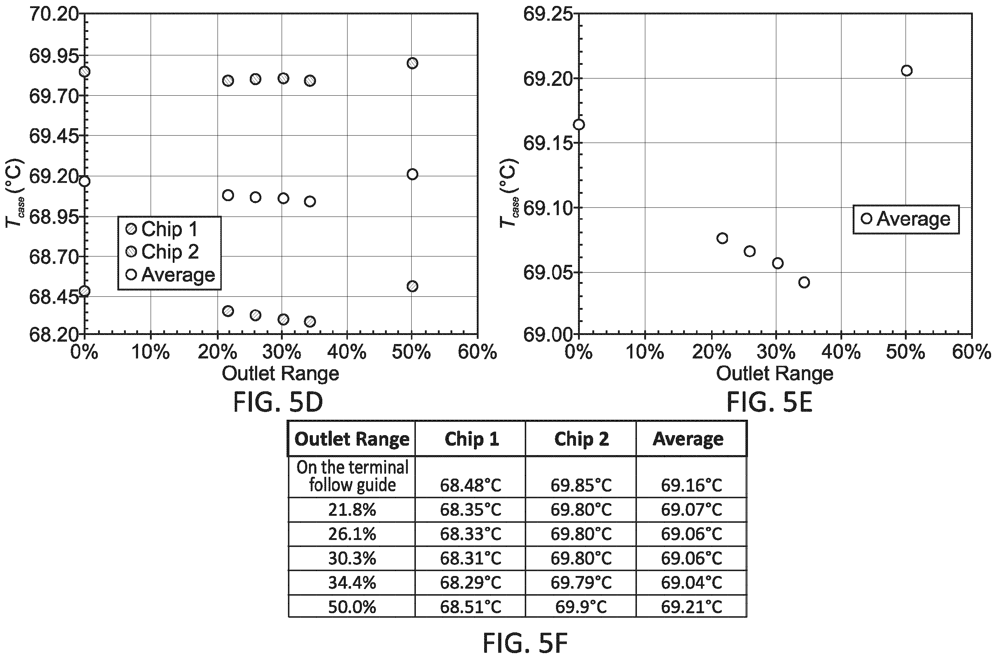

Referring to FIGS. 5A-5C, along with FIG. 2B. FIGS. 5A-5C are schematic diagrams illustrating the top views of immersion cooling modules of FIG. 2B with different top-wall outlet regions. FIGS. 5D-5E are graphs illustrating the relationship between temperature of two heat-generating devices 14, *i.e.,* two chip components, and the top-wall outlet range. FIG. 5F is a table illustrating detailed temperature values for the two heat-generating devices 14, *i.e.,* the two chip components, coupled to the immersion cooling module with different top-wall outlet ranges.

As examples illustrated in FIGS. 5A-5C, the flow-directing housing 111 includes a top wall 203 that defines an opening as a top-wall outlet 204. In one embodiment, the top-wall outlet 204 is located within a designated area referred to as the top-wall outlet region 205. The top-wall outlet region 205 extends from the flow-guiding back plate 303 to a point halfway along the length of the heat-dissipating fins 112, *i.e.,* to the midpoint 1121 (as shown in FIG. 2C) of the dissipating-fins 112. In some embodiments, within the top-wall outlet region 205, the position, size, and shape of the top-wall outlet 204 are not limited. The top-wall outlet 204 can adopt any planar shape or combination thereof, and the number of such outlets can be one or more.

As an example illustrated in FIG. 5A, the top-wall outlet 204 is located on the top of the terminal flow guide 30, with no opening on the top surface of the main housing body 20. As other examples illustrated in FIGS. 5B and 5C, the top-wall outlet 204 can span the top of both the heat dissipating-fins 112 and the terminal flow guide 30 and can include a combination of rectangular and arcuate shapes in varying sizes.

When the top-wall outlet region 205 extends up to the midpoint of the heat dissipating-fins 112, as compared to the configurations where it is located only on the terminal follow guide 30, the cooling performance improves, as shown by the experimental dataset in FIGS. 5D-5E: the temperature of the upstream heat-generating device 14, *i.e.,* Chip 1, can be reduced by up to 0.19°C, the temperature of the downstream heat-generating 14, *i.e.,* Chip 2, can be reduced by up to 0.06°C, and the average temperature of the heat-generating devices 14, *i.e.,* two chip components, can be reduced by up to 0.12°C during operation.

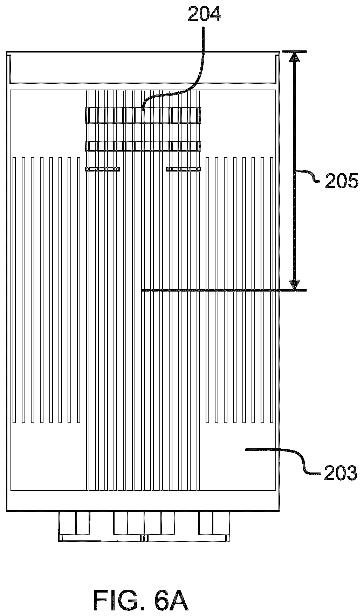

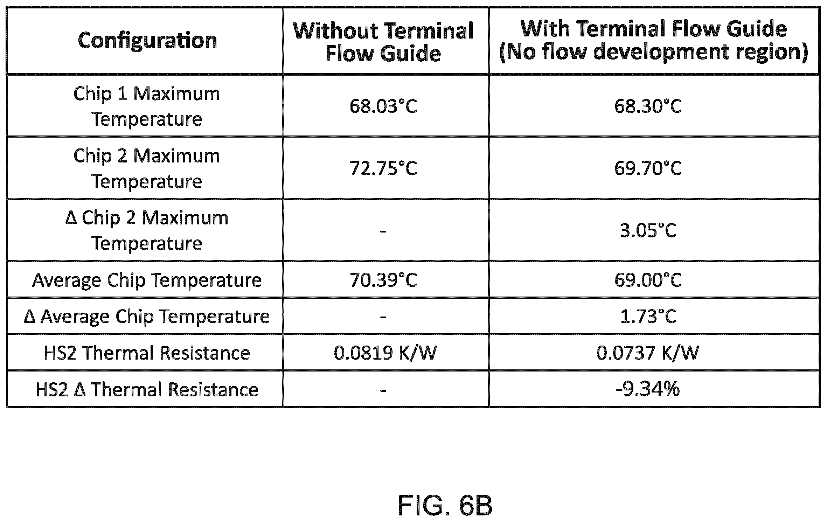

Referring to FIGS. 6A-6B. FIG. 6A is a schematic diagram illustrating a top view of an immersion cooling module according to one embodiment of the present disclosure. FIG. 6B is a table illustrating detailed temperature and thermal resistance values for two heat-generating devices, *i.e.,* two chip components, coupled to the immersion cooling module with and without the terminal flow guide.

As an example illustrated in FIG. 6A, the immersion cooling module 11C is similar to the immersion cooling module 11 in FIG. 2A, so the differences will be described, and the similarities will not be repeated. In one embodiment, more than one top-wall outlet 204 are formed within the top-wall outlet region 205. For example, the top-wall outlet 204 of the immersion cooling module 11C is composed of several discrete rectangular openings. However, the embodiment is not limited thereto. In other embodiments, the number, size, and position of the top-wall outlet 204 are not limited and may be selected based on the desired flow field distribution. Pressure drop and temperature can be efficiently reduced by positioning the top wall outlet 204 appropriately.

As an example illustrated in FIG. 6B, the experiment dataset shows the performance of the immersion cooling module 11C when the heat-generating device 14 is in operation. For example, the presence of the terminal flow guide 30 enables the temperature of the downstream heat-generating device 14, *i.e.,* Chip 2, to be reduced by up to 3.05°C compared to a system without the guiding structure. Additionally, the thermal resistance of the downstream heat-generating device 14, *i.e.,* Chip 2, can be reduced by up to 9.34%.

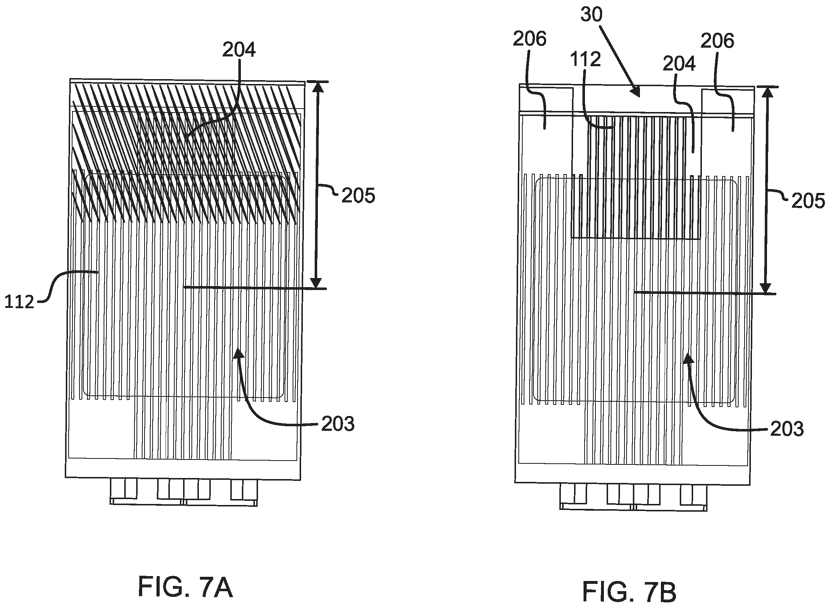

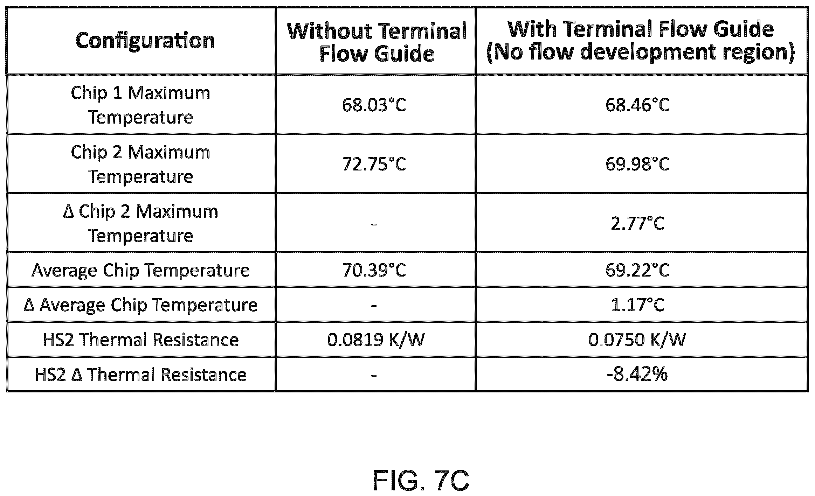

Referring to FIGS. 7A-7C. FIG. 7A is a schematic diagram illustrating a top view of an immersion cooling module according to one embodiment of the present disclosure. FIG. 7B is a schematic diagram illustrating a top view of an immersion cooling module according to one embodiment of the present disclosure. FIG. 7C is a table illustrating detailed temperature and thermal resistance values for the two heat-generating devices, *i.e.,* the two chip components, coupled to the immersion cooling module with and without the terminal flow guide.

As an example illustrated in FIG. 7A, the immersion cooling module 11D is similar to the immersion cooling module 11 in FIG. 2A, so the differences will be described, and the similarities will not be repeated. In one embodiment, the top-wall outlets 204 of the immersion cooling module 11D are arranged in a geometric array of multiple openings. However, the embodiment is not limited thereto. In other embodiments, the top-wall outlets can be arranged irregularly, in staggered patterns, or in configurations optimized for specific flow dynamics, thermal distribution, or structural constraints.

As an example illustrated in FIG. 7B, the immersion cooling module 11E is similar to the immersion cooling module 11D in FIG. 7A, so the differences will be described, and the similarities will not be repeated. Both side portions 206 of the immersion cooling module 11E are connected to the terminal flow guide 30, resulting in a rectangular top-wall outlet 204. However, the embodiment is not limited thereto. In other embodiments, depending on the cooling requirements, one or more top-wall outlet 204 of any size and shape may be formed within the top-wall outlet region 205.

As an example illustrated in FIG. 7C, the experiment dataset shows the performance of the immersion cooling module 11E when the heat-generating device 14 is in operation. For example, the presence of the terminal flow guide 30 enables the temperature of the downstream heat-generating device 14, *i.e.,* Chip 2, to be reduced by up to 2.77°C compared to a system without the guiding structure. Additionally, the thermal resistance of the downstream heat-generating device 14, *i.e.,* Chip 2, can be reduced by up to 8.42%.

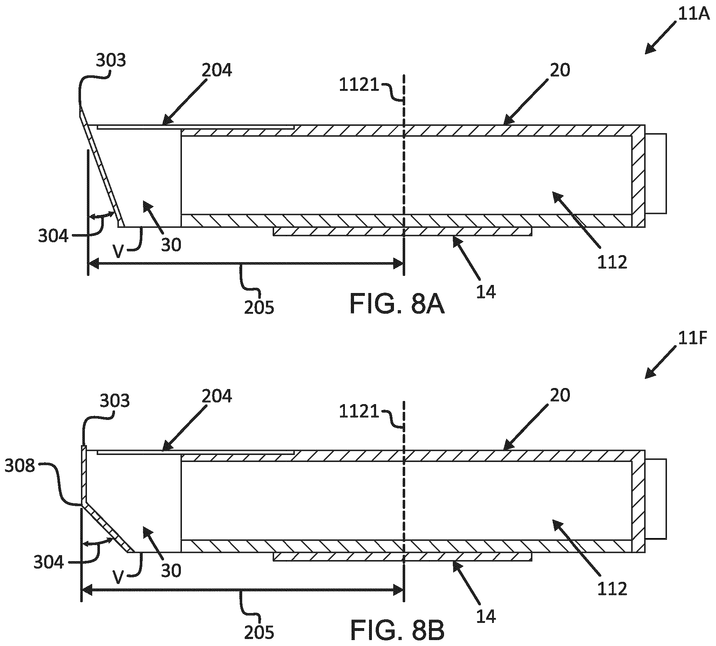

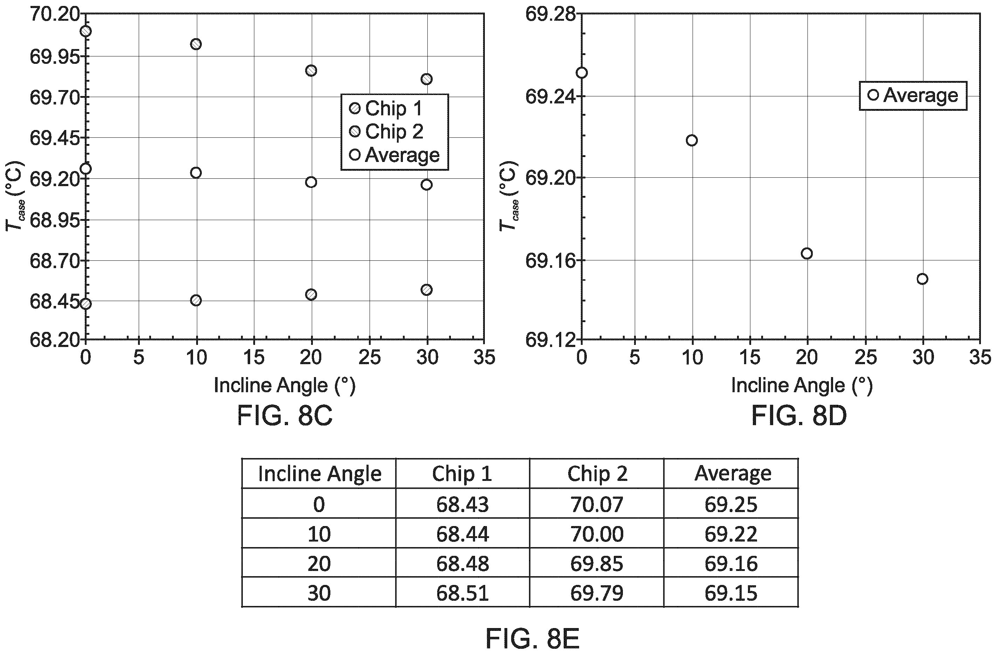

Referring to FIGS. 8A-8E. FIG. 8A is a schematic diagram illustrating a longitudinal cross-sectional view of the immersion cooling module of FIG. 3A. FIG. 8B is a schematic diagram illustrating a longitudinal cross-sectional view of an immersion cooling module according to one embodiment of the present disclosure. FIGS. 8C-8D are graphs illustrating the relationship between the temperature of two heat-generating devices, *i.e.,* two chip components, and the flow-guiding back plate inclination angles. FIG. 8E is a table illustrating detailed temperature values for the two heat-generating devices, *i.e.,* two chip components, coupled to the immersion cooling module with the flow-guiding back plate inclined at different angles.

As an example illustrated in FIG. 8A, the terminal flow guide 30 includes a flow-guiding back plate 303 and a flow development region 302 (as shown in FIG. 3A), forming a flow-guiding back plate inclination angle 304 between them. In one embodiment, the inclination angle 304 may range from 0° to 45°.

As an example illustrated in FIG. 8B, the immersion cooling module 11A is similar to the immersion cooling module 11A in FIG. 3A, so the differences will be described, and the similarities will not be repeated. In one embodiment, the flow-guiding back plate 303 of the terminal flow guide structure 30 may be formed with one or more bends 308.

According to the embodiment, when the inclination angle 304 is set to 30°, the temperature of the downstream of the heat-generating device 14, *i.e.,* Chip 2, during operation can be reduced by approximately 0.28°C compared to a configuration where the angle is 0°.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. Of course, the disclosed embodiments are merely exemplary embodiments and that various modifications can be made without departing from the spirit and scope of the disclosure. Further, it should be understood that various aspects of the embodiment are not mutually exclusive of each other and can be combined as desired by a person of ordinary skill in the art as a matter of design choices.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. An immersion cooling module (11), comprising:
a flow-directing housing (111) that includes a main housing body (20) and a terminal flow guide (30), the main housing body (20) having an inlet face (201) and a top wall (203) that defines at least one top-wall outlet (204), and the terminal flow guide (30) being coupled to the main housing body (20) on a side opposite the inlet face (201);
a plurality of heat-dissipating fins (112) disposed within the main housing body (20); and
at least one fluid driver (113) mounted to the inlet face (201).

2. The immersion cooling module (11) of claim 1, wherein the terminal flow guide (30) includes a flow-guiding back plate (303) and a base that together define a flow development region (302).

3. The immersion cooling module (11) of claim 2, wherein the top-wall outlet (204) is located within a top-wall outlet region (205) that extends from the flow-guiding back plate (303) to a midpoint (1121) of the heat-dissipating fins (112).

4. The immersion cooling module (11) of claim 2 or 3, wherein the flow development region (302) has a length between 2 mm and 20 mm.

5. The immersion cooling module (11) of at least one of claims 2 to 4, wherein the flow-guiding back plate (303) is inclined at an angle between 0° and 45° relative to the flow development region (302).

6. The immersion cooling module (11) of at least one of claims 2 to 5, wherein the flow-guiding back plate (303) includes one or more bends (308).

7. The immersion cooling module (11) of claim 6, wherein the bend (308) in the flow-guiding plate (303) forms at least two angled segments.

8. The immersion cooling module (11) of at least one of claims 1 to 7, wherein the top-wall outlet (204) includes multiple discrete rectangular openings.

9. The immersion cooling module (11) of at least one of claims 1 to 8, wherein the top-wall outlet (204) is arranged in a geometric array.

10. An immersion cooling device (10), comprising:
a tank (12) that contains a working fluid; and
at least two immersion cooling modules (11) according to at least one of claims 1 to 9 that are arranged in series within the tank (12) and are submerged in the working fluid,
each immersion cooling module (11) thermally coupled to a corresponding heat-generating device (14),.

11. The immersion cooling device (10) of claim 10, wherein the at least two immersion cooling modules (11) are spaced apart by a spacing (13) that is adjustable.

12. The immersion cooling device (10) of claim 10 or 11, wherein the fluid driver (113) generates forced convection to transport heated working fluid from the heat-dissipating fins (112) to the top-wall outlet (204).
